# EUROPEAN PATENT SPECIFICATION

(11) **EP 0 745 705 B1**
(45) Date of publication and mention of the grant of the patent: **25.11.1998**
(21) Application number: 96107508.2
(22) Date of filing: 21.05.1996
(51) Int. Cl.: C30B 15/12

(54) **Method of manufacturing a double-crucible for the Czochralski growing technique**
Verfahren zur Herstellung eines Doppeltiegels für das Czochralski-Verfahren
Procédé de fabrication d'une double creuset employé dans la méthode de Czochralski

(30) Priority: 31.05.1995 JP 155616/95
(43) Date of publication of application: 04.12.1996
(73) Proprietor: Heraeus Quarzglas GmbH, 63450 Hanau (DE); SHIN-ETSU QUARTZ PRODUCTS CO., LTD., Shinjuku-ku, Tokyo (JP)
(72) Inventor: Watanabe, Hiroyuki, c/o Shin-Etsu Quartz Products, Takefu-shi, Fukui (JP); Sato, Tatsuhiro, c/o Shin-Etsu Quartz Products, Takefu-shi, Fukui (JP); Matsui, Hiroshi, c/o Shin-Etsu Quartz Pr. Co., Ltd, Koriyama-shi, Fukushima (JP)
(74) Representative: Staudt, Armin Walter

(56) References cited:
- EP-A- 0 283 903
- EP-A- 0 610 065

## Description

### Industrial Field of Application

The present invention generally relates to a method of manufacturing a double-crucible for the Czochralski growing technique and, more particularly relates to a method of manufacturing a double-crucible for the Czochralski growing technique with which silicon single crystal rods are continuously pulled.

### Prior Art

The so-called Czochralski method has been used for growing a silicon single crystal rod wherein a single crystal seed is dipped in a melt contained in a crucible and the seed is then pulled up gradually while being rotated to grow single crystal at the lower end of the seed. There is a need to feed raw material to the melt during a pulling process because of a size limitation in manufacture of a crucible, in case that a single crystal having a larger length and larger diameter is aimed to grow, such a larger single crystal being indispensable to attain a further cost down per a silicon chip for a semiconductor device. For this purpose, a crucible for a double-crucible growing technique (hereinafter referred to as a dual crucible) was developed, which more particularly comprises an inner crucible to grow a single crystal therein and an outer crucible to feed a raw material, a capillary opening as a melt pass being formed in the inner crucible to feed a melt in the outer crucible into the inner crucible.

As to a method of manufacturing a dual crucible, it has been manufactured by means of an oxygen-hydrogen burner or the like, in which an inner crucible is fixed by welding to an outer crucible, each having been already completed as a crucible. In such a method, much labor and time are consumed in welding and it causes the productivity to be decreased or is resulted in a costly dual crucible. In order to pare down the cost of a crucible, for example, a second method was proposed, in which outer and inner crucibles are welded to each other by both softening in a susceptor, which is disclosed in a publication of Unexamined Japanese Patent Application No. SHO 63-233092. The second method, however, has many technical problems that firstly welding between crucibles is not proper enough because it exploits an ability of deformation of the crucibles by softening at a high temperature, secondly it uses an inner crucible having a bottom and, therefore, needs a complex mechanical processing such as drilling a proper hole in the bottom of the inner crucible at a position just opposite to the center of the bottom of an outer crucible, such complexity retarding a decrease in the cost, and thirdly there can be a risk to leak a melt through pinholes remaining in the welded portion when the accuracy in machining is poor.

### Problem the Invention Seeks to Solve

In view of such a current state of the art, the inventors of the present invention have intensively been investigating to solve these faults, and completed the present invention through a discovery that characteristics of a welded portion between crucibles are improved and at the same time the cost of a dual crucible is decreased, by welding an inner crucible member in the shape of a hollow cylinder to an outer crucible member while a temperature of the outer crucible still remains high by a remaining heat from a previous operation.

It is, therefore, an object of the present invention to provide a method of manufacturing a quartz dual-crucible excellent in characteristics of welded portion between crucibles.

It is another object of the present invention to provide a method of manufacturing a quartz dual crucible at a low manufacturing cost and with a higher productivity.

### Brief Description of the Drawings

FIG. 1 is a schematic side elevation view, partly in vertical section, illustrating the main parts of an apparatus of manufacturing an outer quartz crucible member according to the present invention.

FIG.2 is a schematic side elevation view, partly in vertical section, illustrating the main parts of an apparatus of welding an inner quartz crucible member to an outer crucible member according to the present invention.

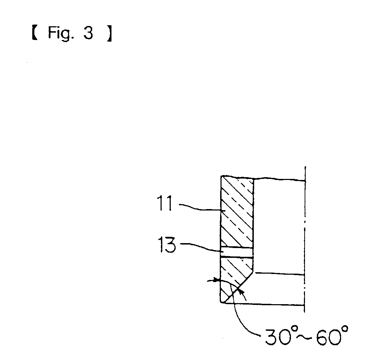

FIG. 3 is a enlarged fragmentary sectional view of the lower end portion of an inner quartz crucible member.

### Means to Solve the Problem

The present invention is a method of manufacturing a double-crucible for the Czochralski growing technique which comprises the steps of; feeding quartz powder into a rotating mold; forming a crucible-like quartz powder body with the help of a centrifugal force in the mold; melting the inner surface portion of the body by heating with an arc discharge to manufacture an outer crucible member manufacturing an inner crucible member in the shape of a hollow cylinder having an outside diameter in the range between 70% and 90% of the inside diameter of the outer crucible member and having at least one opening in its lower part for melt pass, and welding the inner crucible member to the inner surface portion of the outer crucible member by keeping a concentric relation while the temperature of the inner surface portion of the outer crucible member remains at 1400 °C or higher by a remaining heat from heating with the arc discharge.

Three methods are named as methods of manufacturing an outer crucible member. A first method comprises the steps of: feeding quartz powder in a rotating mold; forming a quartz powder layer body in the shape of a crucible; and melting the body by heating the inner surface with an arc discharge. A second method comprises the same steps as those in the first method except that the mold has gas-permeable side and bottom portions and the quartz powder layer body is melted by heating while the gas in the quartz layer is drawn by means of a vacuum device, which is disclosed in a publication of Unexamined Japanese Patent Application No. SHO 56-149333. A third method comprises the steps of feeding crystalline quartz powder or amorphous quartz powder in a quartz glass substrate while rotating, the substrate being manufactured by means of the first method or the second method; and melting the powder by heating to form a transparent layer on the inner surface of the substrate, which is disclosed in a publication of Unexamined Japanese Patent Application No. HEI 4-22861.

On the other hand, an inner crucible member, which has the shape of a hollow cylinder, has at least one, preferably 2 to 4, capillary opening for melt pass in the lower part and is mechanically finished so as to have an outside diameter of 70% to 90% of the inside diameter of the outer crucible member. Melt of raw material fed to the outer crucible is introduced into the inner crucible through the above mentioned opening for melt pass and thus continuous silicon single crystal growth can be realized. Especially when 2 to 4 openings for melt pass are provided, not only oscillation in height but also fluctuation in temperature of the melt surface in the inner crucible can be favorably suppressed. The precision of welding can be improved and thereby no bubble is produced in a junction when the lower end surface is inwardly inclined at about 30 degrees to 60 degrees from the side walls and the sharpened edge of the lower end is finished by grinding with a gap or error of 1 mm or less from a plane perpendicular to the inner crucible axis.

An inner crucible member is finished by mechanically processing of a quartz cylindrical hollow body, as described above, and it is preferable that the inner crucible member machined is further heated and cooled in order to remove strains and the surface is still further smoothed by fire polishing.

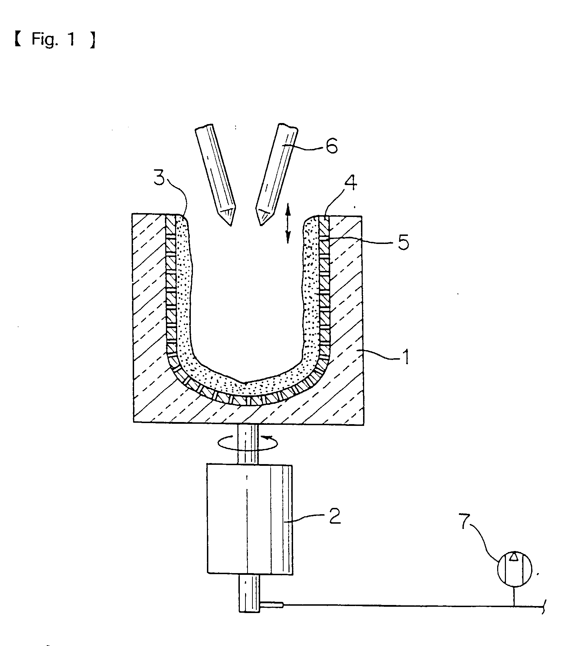

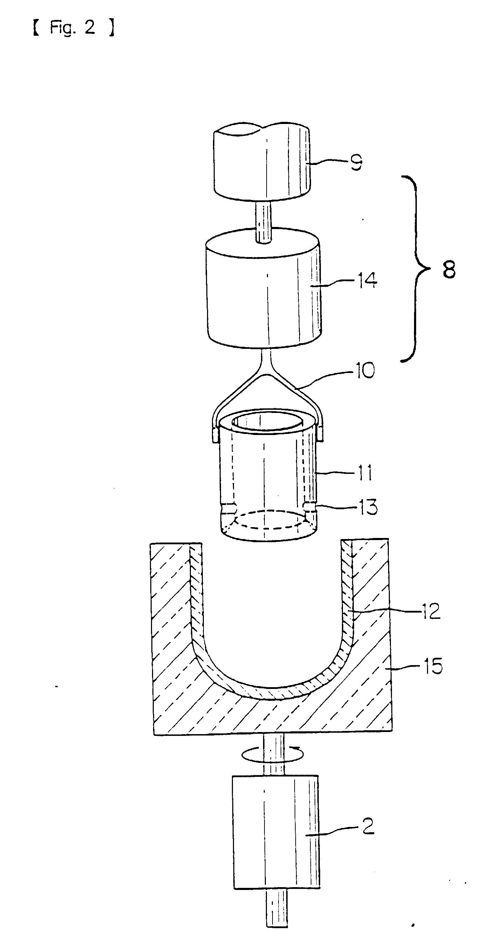

A method of manufacturing according to the present invention has a step of welding an inner crucible member with an outer crucible member, while a temperature of the inner surface portion of the outer crucible member still remains at a temperature of 1400 °C or higher by a remaining heat in the mass after manufacture of the outer crucible member in order to manufacture a quartz dual crucible, wherein a temperature of the outer crucible member at welding is especially preferred to be 1800 °C or higher. When the welding is conducted at a temperature of 1800 °C or higher, the crucibles well welded to each other and thereby the production yield of good dual crucibles is increased. At a temperature of welding being lower than 1400 °C, a poor junction between the members is apt to occur and, as a result, leakage of a melt is often resulted in. The following description is made about a method of manufacturing according to the present invention taking up a case, as an example, that an embodiment is carried out starting from an outer crucible member obtained in the above mentioned second method. The method comprises the steps of: feeding quartz powder into a mold 4 which is hollow inside and open upward and which has a plurality of gas-permeable through-holes 5 on the side, while rotating on a rotation driving device 2, to preform a crucible-like crystalline quartz powder layer body 3 having an upward opening; applying heat to and melting the layer body 3 through the inner surface with an arc discharge electrodes 6 shifted down and at the same time under vacuum-suction by way of the through-holes 5 which are in turn communicated with each other in a cavity inside a support 1 which is further communicated with a vacuum pump 7; transporting the obtained opaque outer crucible member together with a manufacturing apparatus, the crucible member being placed in the apparatus as it was when being manufactured, to a place where a welding apparatus of an inner crucible member is installed; contacting an inner crucible member 11 to a part inside the outer crucible member 12, which has stopped rotating and the temperature of which remains at a temperature of at lowest 1400 °C, or preferably 1800 °C or higher by a remaining heat, by lowering the inner crucible member 11 suspended from a crucible holder 10 of a holder elevator 9 while keeping a concentric relation with the outer crucible member 12; and pressing the inner crucible member 11 by way of the crucible holder 10 to the outer crucible member 12 fixedly supported in a graphite mold 15 with an upward opening to complete a welding as shown in FIG. 2. An outside diameter of the inner crucible member 11 is in the range of 70 % to 90 % of an inside diameter of the outer crucible member 12. When an outside diameter of the inner crucible member 11 is smaller than 70 % of an inside diameter of the outer crucible member 12, the cost per a chip goes up. On the other hand when an outside diameter of the inner crucible member 11 is larger than 90 % of an inside diameter of the outer crucible member 12, melt supply to the inner crucible 11 is not ample enough and not only a height but also temperature of the surface of the melt in the inner crucible 11 is fluctuated and as a result a single crystal with a good quality cannot be grown. In a method shown in FIG. 1, an opening 13 for melt pass is formed in the lower part of the inner crucible member 11. The lower end surface of the inner crucible member 11 has an angle between about 30 degrees to 60 degrees inclined inwardly from the side walls and the sharpened edge of the lower end is aligned with a plane perpendicular to the axis with a gap or error of 1 mm or smaller, so that a good quartz dual crucible without no bubble generated in the junction.

In the above mentioned manufacturing method, cracking does not occur and a chance to damage a quartz dual crucible becomes small when the inner crucible member is preheated with a crucible heater 14 mounted in the holder elevator 9 to a temperature roughly equal to a temperature of the outer crucible member which is still high by a remaining heat after manufacture and then welded with the outer crucible member at the temperature.

An arc discharge used in a method of manufacturing according to the present invention is capable of heating an object to a temperature of the order of 3000 °C. A temperature of a molten crucible surface heated by the arc discharge is raised to a temperature close to 2000 °C. Consequently, the remaining heat can easily keep a temperature of the inner surface of an outer crucible at 1400 °C or higher, or with skill, 1800 °C or higher and thus energy saving is also achieved.

### Examples

Examples of the present invention will be described in detail. It is to be expressly understood that the details described in the examples are shown only for the purpose of illustration and not restricted to define the scope of concepts of the present invention, unless specially stated.

### Example 1

An inner crucible member was mechanically finished from a quartz workpiece in the shape of a hollow cylinder to the dimensions of the outside diameter being 80 % of the inner diameter of an outer crucible member and the height being 70 % of the depth of the outer crucible member and at the same time two openings for melt pass were also formed mechanically in the lower part. The inner crucible member thus obtained was welded to the outer crucible member, which had been manufactured by means of a method shown in FIG. 1, as a result, to manufacture a quartz dual crucible, while the temperature of the outer crucible remained at 1800 °C by a remaining heat. The observation is shown in Table 1.

### Example 2

The lower end of an inner crucible member was heated to 1800 °C with a crucible heater 14 and then joined to an outer crucible member by welding. The other steps of manufacturing a quartz dual crucible were the same as those of Example 1. The observation is shown in Table 1.

### Example 3

A quartz dual crucible was manufactured in the same way as in Example 2 except that the lower end of an inner crucible member was sharpened by mechanically processing so that the angle between the lower surface of the lower end and the side walls was 45 degrees inclined counterclockwise from the side walls. The observation is shown in Table 1.

### Comparative Example 1

A quartz dual crucible was manufactured in the same way as in Example 1 except that welding of an inner crucible member to an outer crucible member was conducted at 1200 °C of a remaining heat. The observation is shown in Table 1.

**Table 1**

| Nos. of Examples | Observations |
|---|---|
| 1 | Welding was carried out in a short time, but a few bubbles were generated in the interface of a dual crucible. |
| 2 | Welding was completed in a good order with a decreased number of bubbles in the interface of a dual crucible. |
| 3 | Welding was completed in a good order with no bubble in the interface of a dual crucible and the production yield is good. |
| Comp. 1 | Poor welding was resulted. |

### Effects of the Invention

In a method of manufacture according to the present invention, a quartz crucible for a double-crucible growing technique can be manufactured with excellent characteristics of junction, a low production cost and a high production yield. Silicon single crystal rods each having a larger diameter are continuously pulled in a quartz crucible for a double-crucible growing technique according to the present invention in a satisfactory manner.

## Claims

1. A method of manufacturing a double-crucible for the Czochralski growing technique comprising the steps of: feeding quartz powder into a rotating mold; forming a crucible-like quartz powder layer body with the help of a centrifugal force in the mold; melting the inner surface portion of the body by heating with an arc discharge to manufacture an outer crucible member; manufacturing an inner crucible member in the shape of a hollow cylinder having an outside diameter in the range between 70 % and 90 % of the inside diameter of the outer crucible member and having at least one opening in its lower part for melt pass, and welding the inner crucible member to the inner surface portion of the outer crucible member by keeping a concentric relation, while the temperature of the inner surface portion of the outer crucible member remains at 1400 °C or higher by a remaining heat from heating with the arc discharge.

2. A method of manufacturing a double-crucible for the Czochralski growing technique according to claim 1, wherein the inner crucible member is welded to the outer crucible member, after the inner crucible member is preheated at a temperature of 1400 °C or higher.

3. A method of manufacturing a double-crucible for the Czochralski growing technique according to claim 1, wherein the surface of the lower end of the inner crucible member is inwardly inclined at 30 degrees to 60 degrees with respect to the side walls.

4. A method of manufacturing a double-crucible for the Czochralski growing technique according to claim 3, wherein the sharpened edge of the lower end of the inner crucible member is aligned with a plane perpendicular to the inner crucible axis with a gap of 1 mm or less.

## Patentansprüche

1. Verfahren zur Herstellung eines Doppeltiegels für das Czochralski- Kristallziehen, das folgende Schritte umfaßt: Einfüllen von Quarzpulver in eine rotierende Form; Bilden eines tiegelähnlichen Körpers aus Quarzpulverschichten in der Form mit Hilfe der Zentrifugalkraft; Schmelzen des Innenflächenteils des Körpers durch Erhitzen mittels Bogenentladung zur Herstellung eines Außentiegels; Herstellen eines Innentiegels in Form eines Hohlzylinders mit einem Außendurchmesser von 70 % bis 90 % des Innendurchmessers des Außentiegels, der mindestens eine Durchlaßöffnung für die Schmelze im unteren Teil aufweist, wobei der Innentiegel mit dem Innenflächenteil des Außentiegels rundum verschweißt ist und der Innenflächenteil des Außentiegels durch stetiges Erhitzen mittels Bogenentladung auf einer Temperatur von 1400°C oder mehr gehalten wird.

2. Verfahren zur Herstellung eines Doppeltiegels für das Czochralski- Kristallziehen nach Anspruch 1, dadurch gekennzeichnet, daß der Innentiegel mit dem Außentiegel verschweißt wird, nachdem der Innentiegel auf eine Temperatur von 1400°C oder mehr vorgewärmt wurde.

3. Verfahren zur Herstellung eines Doppeltiegels für das Czochralski- Kristallziehen nach Anspruch 1, dadurch gekennzeichnet, daß die Fläche des unteren Endes des Innentieges eine Neigung von 30 bis 60 Grad nach innen in bezug auf die Seitenwände aufweist.

4. Verfahren zur Herstellung eines Doppeltiegels für das Czochralski- Kristallziehen nach Anspruch 3, dadurch gekennzeichnet, daß die geschärfte Kante des unteren Endes des Innentiegels mit der Ebene rechtwinklig zur Achse des Innentiegels angebracht ist und eine Lücke von 1 mm oder weniger bildet.

## Revendications

1. Procédé de fabrication d'un creuset double pour la technique de croissance Czochralski comprenant les étapes suivantes : amenée de la poudre de quartz à l'intérieur d'un moule rotatif ; formation d'un corps à partir d'une couche de poudre de quartz en forme de creuset à l'aide d'une force centrifuge dans le four ; fonte de la partie interne de surface du corps en chauffant par une décharge en arc pour fabriquer un organe externe de creuset ; fabrication d'un organe interne de creuset sous forme d'un cylindre creux présentant un diamètre externe compris entre 70 % et 90 % du diamètre interne de l'organe externe du creuset et présentant au moins une ouverture dans sa partie inférieure pour le passage de la fusion et fonte de l'organe interne de creuset à la partie de surface interne de l'organe externe de creuset en conservant une relation concentrique tandis que la température de la partie interne de surface de l'organe externe de creuset est mantenue à 1400°C ou plus par l'action d'une chaleur résiduelle provenant du chauffage par la décharge en arc.

2. Procédé de fabrication d'un double creuset pour la technique de croissance de Czochralski selon la revendication 1, dans lequel l'organe interne de creuset est fondu en direction de l'organe externe de creuset après avoir préchauffé l'organe interne de creuset à une température supérieure ou égale à 1400°C.

3. Procédé de fabrication d'un double creuset pour la technique de croissance de Czochralski selon la revendication 1, dans lequel la surface de l'extrémité inférieure de l'organe interne de creuset est inclinée vers l'intérieur de 30 degrés à 60 degrés par rapport aux parois latérales.

4. Procédé de fabrication d'un double creuset pour la technique de croissance de Czochralski selon la revendication 3, dans lequel l'arête vive de l'extrémité inférieure de l'organe interne de creuset est alignée à un plan perpendiculaire à l'axe interne du creuset avec un jour inférieur ou égale à 1 mm.
